# EUROPEAN PATENT SPECIFICATION

(11) **EP 3 154 327 B1**
(45) Date of publication and mention of the grant of the patent: **01.07.2020**
(21) Application number: 15802350.7
(22) Date of filing: 21.05.2015
(51) Int. Cl.: H05K 13/04, H05K 13/08

(54) **COMPONENT MOUNTING DEVICE**
KOMPONENTENMONTAGEVORRICHTUNG
DISPOSITIF DE MONTAGE DE COMPOSANTS

(30) Priority: 03.06.2014 JP 2014114987
(43) Date of publication of application: 12.04.2017
(73) Proprietor: Yamaha Hatsudoki Kabushiki Kaisha, Iwata-shi, Shizuoka-ken 438-8501 (JP)
(72) Inventor: KOMAIKE, Kunimune, Iwata-shi, Shizuoka-ken 438-8501 (JP); KAMASUKA, Hideyuki, Ota-shi, Gunma 373-0833 (JP); KANAI, Osamu, Ota-shi, Gunma 373-0847 (JP)
(74) Representative: Müller-Boré & Partner Patentanwälte PartG mbB
(86) International application number: PCT/JP2015/064652
(87) International publication number: WO 2015/186530

(56) References cited:
- JP-A- H0 983 198
- JP-A- H0 983 198
- JP-A- H11 147 507
- JP-A- 2002 353 693
- JP-A- 2005 285 840
- JP-A- 2006 351 911
- JP-A- 2013 251 346
- US-A1- 2002 069 524

## Description

### Technical Field

The present invention relates to a component mounting apparatus for extracting a component from a component supply unit and mounting the component onto a substrate by using a holder.

### Background Art

For example, Patent Literature 1 discloses a technique of detecting, after a suction nozzle (holder) sucks an electronic component, whether the component is sucked on the suction nozzle or a posture of the sucked component.

However, the conventional technique only allows the detection of the state of the component after the extraction thereof and, thus, provides no way to know the state of the component when it is supplied. Accordingly, it has been difficult to perform appropriate procedures to reliably extract a component.

### Citation List

### Patent Literature

Patent Literature 1: Japanese Unexamined Patent Publication No. 2009-60131

US 2002/069524 A1 and JP H09 83198 A disclose an apparatus for detecting, after a component supplied to a predetermined supply position is sucked by a nozzle, whether or not the sucked component is in an abnormal state.

JP H11 147507 A discloses a semiconductor device taping equipment which fully automatically detects the posture of the semiconductor device, corrects the posture of defective device, and enables price reduction by reducing the number of manhowrs.

### Summary of Invention

The object of the present invention is to provide a component mounting apparatus capable of performing appropriate procedures to reliably extract a sucked component.

A component mounting apparatus according to an aspect of the present invention is defined in claim 1.

The objects, features and advantages of the present invention will become more apparent upon reading the following detailed description along with the accompanying drawings.

### Brief Description of Drawings

FIG. 1 is a plan view of an electronic component mounting apparatus according to an embodiment of the present invention.
FIG. 2 is a side view of a mounting head in the electronic component mounting apparatus.
FIG. 3 is a top plan view of the mounting head.
FIG. 4 is a control block diagram particularly relating to imaging and recognition processing of an electronic component performed in the electronic component mounting apparatus.
FIG. 5 is a diagram showing an image of an electronic component extraction position captured by an imaging camera.
FIG. 6 is a side view of the mounting head which illustrates imaging of an electronic component performed by the imaging camera.
FIG. 7 is a flowchart of component suction and mounting.
FIG. 8A is a diagram showing an image of the component extraction position captured by the imaging camera.
FIG. 8B is a diagram showing another captured image of the component extraction position.
FIG. 8C is a diagram showing another captured image of the component extraction position.

### Description of Embodiments

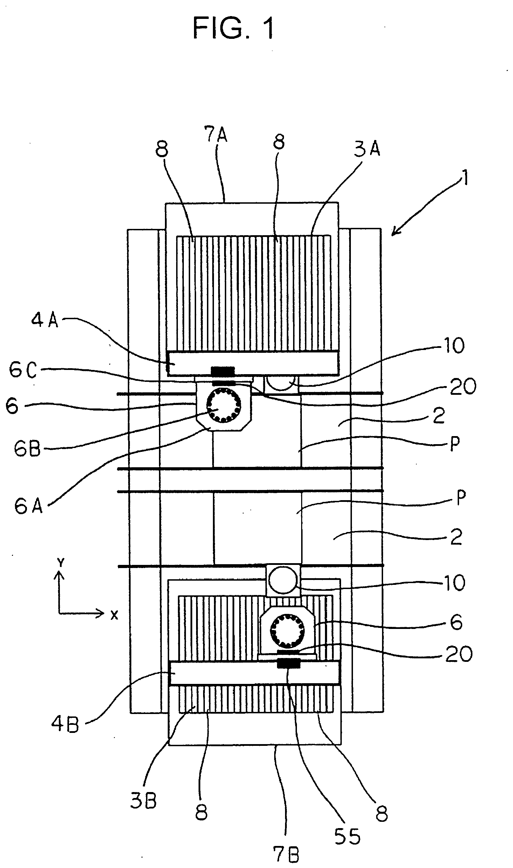

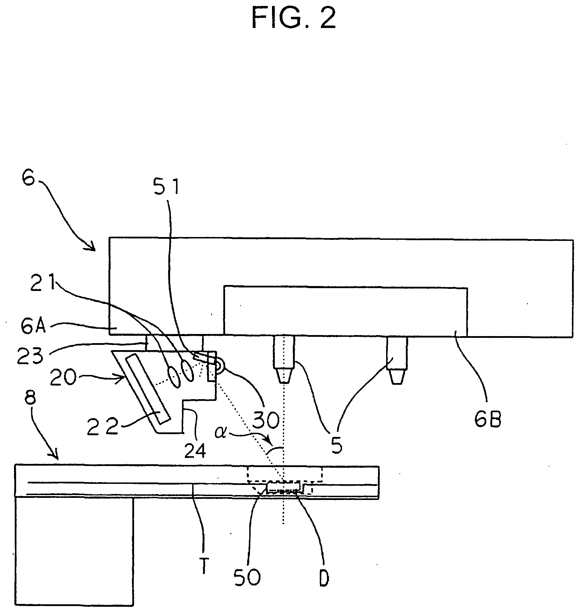

First, with reference to FIG. 1, an electronic component mounting apparatus 1 according to an embodiment of the present invention will be described which mounts electronic components D onto a print substrate P serving as a substrate. The electronic component mounting apparatus 1 includes conveyor devices 2 for respectively conveying print substrates P, component feeder devices 3A and 3B which are respectively disposed at a front side and a rear side of an apparatus body of the electronic component mounting apparatus 1 and feed electronic components D, a pair of beams 4A and 4B which are movable by driving sources in one direction (reciprocally movable in Y direction), and a pair of mounting heads 6 which are individually movable by respective driving sources in a direction along the beams 4A and 4B (in X direction perpendicularly intersecting the Y direction). The mounting heads 6 will be described later with reference to FIG. 2.

The conveyor device 2 positions and secures a print substrate P to a positioning section placed at substantially the center of the apparatus body by using an unillustrated positioning device.

The component feeder devices 3A and 3B are respectively disposed in front of and behind the conveyor devices 2, and each include a plurality of component supply units 8 which are arranged side by side on a feeder base of a cart stand 7A, 7B serving as a mounting stand. The component supply unit 8 advances a storage tape T (FIG. 2) storing electronic components D to thereby supply an electronic component D to be mounted onto a print substrate P to a predetermined supply position. Each of the cart stands 7A and 7B is detachably mounted on the apparatus body via a connecting tool in such a manner that an end of the component supply unit 8 on a component feeding side faces a conveyance passage of a print substrate P. When the cart stand 7A, 7B is properly mounted on the apparatus body, the power is supplied to the component supply unit 8 mounted on the cart stand 7A, 7B. Further, a worker can move the cart stand 7A, 7B by releasing the connecting tool and pulling an unillustrated handle owing to castors disposed on a bottom surface of the cart stand 7A, 7B.

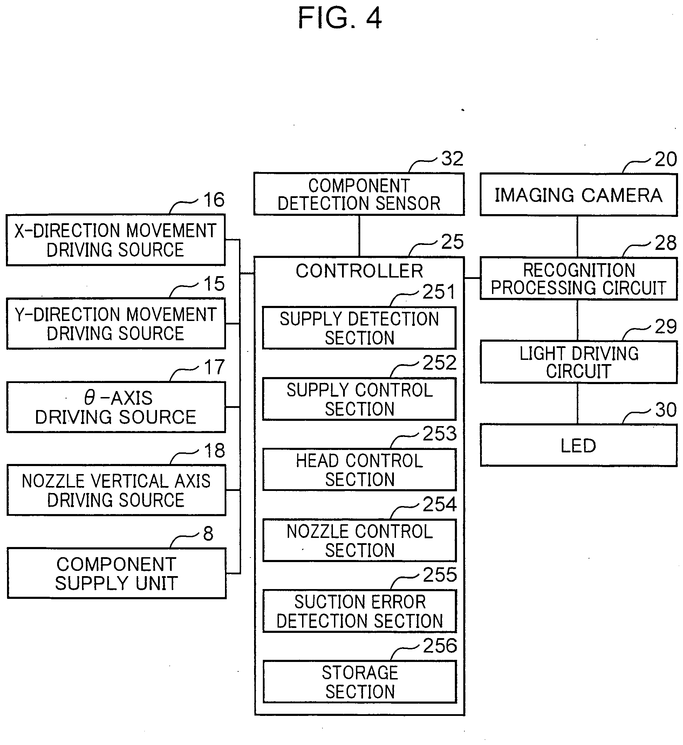

The beams 4A and 4B are in the form of a pair of front and rear members having a longer dimension in the X direction. Unillustrated sliders respectively secured to the beams 4A and 4B are each driven to slide along a pair of unillustrated left and right guides extending in the front-rear direction by a Y-direction movement driving source 15 (FIG. 4) including a linear motor, whereby the beams 4A and 4B move individually in the Y direction.

Further, the beams 4A and 4B are each mounted with the mounting head 6 movable in the horizontal direction. The mounting head 6 is disposed on an inner side of the beam 4A, 4B in such a manner as to be driven, by a X-direction movement driving source 16 (FIG. 4) including a linear motor, to move along a guide extending in a longitudinal direction of the beam 4A, 4B (in the X direction). The X-direction movement driving source 16 includes a pair of unillustrated front and rear stators secured to the beam 4A, 4B, and an unillustrated rotor disposed between the stators and on the mounting head 6.

The pair of mounting heads 6 are respectively disposed on the inner sides of the beams 4A and 4B and face each other. The rear mounting head 6 can extract an electronic component from the component supply unit 8 of the corresponding rear component feeder device 3A and mount it onto a print substrate P placed on the conveyor device 2. The front mounting head 6 can extract an electronic component from the component supply unit 8 of the corresponding front component feeder device 3B and mount it onto the print substrate P.

Each mounting head 6 includes a stationary head mounting body 6A, a rotary body 6B in the form of a cylinder having a circular shape in a top plan view, and a mounting member 6C via which the head mounting body 6A and the rotary body 6B are movably mounted to the beam 4A, 4B. The rotary body 6B is rotatable about a vertical axis by a θ-axis driving source 17. On a peripheral portion of the rotary body 6B, a plurality of suction nozzles 5 serving as holders of components are disposed at predetermined intervals in a circle about the center of the rotation. The suction nozzle 5 is vertically movable by a vertical axis driving source 18 and can perform extraction of an electronic component D from the component supply unit 8 by vacuum suction and mounting of the extracted electronic component D onto a print substrate P by stopping of the vacuum suction. The rotary body 6B rotates with respect to the mounting head 6 and the stationary head mounting body 6A.

The component supply unit 8 advances the storage tape T by a predetermined pitch by driving of an unillustrated sprocket to position and stop a storage portion 50 storing an electronic component D at a predetermined component supply position (component extraction position), the storage tape T being successively fed from a state wound around an unillustrated feeding reel rotatably placed on the cart stand 7A, 7B (see FIG. 2). In order to execute this operation, the component supply unit 8 includes a tape feeding mechanism for intermittently advancing the storage tape T to the extraction position of electronic components D, and a cover tape peeling mechanism for peeling a cover tape from the storage tape T. The feed sprocket is rotated by a predetermined angle by a feed motor to thereby allow the tape feeding mechanism to intermittently advance the storage tape T, the sprocket including teeth engageable with advancing holes formed at predetermined intervals in the storage tape T. The storage tape T includes a carrier tape constituting a lower portion thereof and including storage portions 50, and the cover tape covering the top of the carrier tape. The cover tape peeling mechanism peels the cover tape from the carrier tape before the supply position by driving of a peeling motor. The storage portions 50 of the carrier tape are in the form of recesses formed at predetermined intervals (at the above-mentioned predetermined pitches) in an advancing direction of the storage tape T, the recesses being also called as pockets. The component supply unit 8 successively feeds the electronic components D placed in the storage portions 50 to the component supply position while peeling the cover tape by the tape peeling mechanism.

There are component recognition cameras 10 which each image electronic components D that are held by suction on the suction nozzles 5 disposed on the rotary body 6B at once from below before the electronic components D are mounted onto a print substrate P. The imaging is performed by illuminating the electronic components D held by suction on the suction nozzles 5 with light emitted from an unillustrated lighting unit provided near the recognition camera 10 and capturing its reflected image by the recognition camera 10. In the capturing of the reflected image, an image of portions of the electronic components D that reflect the light, such as leads, are captured. Therefore, an erroneous recognition may occur if there is a portion of the background that is likely to reflect the light. Accordingly, conditions of the background are so set as to be imaged darkly in the imaging. For example, lower end surfaces of the suction nozzles 5 shown in FIG. 2 and a lower portion of the mounting head 6 (including a lower surface of the rotary body 6B) that are imaged in the background are painted in black or the like.

A component detection sensor 32 (extraction detector) is disposed on a lower portion of the head mounting body 6A of the mounting head 6. The component detection sensor 32 detects, after an electronic component D is extracted from the component supply unit 8, whether the electronic component D is normally held on the suction nozzle 5. Specifically, the component detection sensor 32 detects whether the electronic component D sucked on the suction nozzle 5 is in an abnormal state such as an oblique state or raised state (component standing), or whether the electronic component D has failed to be sucked (the electronic component D is not sucked on the suction nozzle 5).

Hereinafter, the above-mentioned abnormal state or failure of the suction of the electronic component will be collectively referred to as suction error (extraction error). The determination of whether a suction error occurs can be made by using an optical sensing method. For example, beams of lights spreading in a vertical direction are shone on the electronic component D from a central portion of the rotary body 6B surrounded by the plurality of suction nozzles 5 to allow the component detection sensor 32 to detect a vertical level at which the electronic component D blocks the light beams. A suction error determination section 255 (extraction detector; see FIG. 4) of a controller 25 determines whether a suction error occurs by calculating the thickness of the electronic component D based on the detected light shielding vertical level. In other words, the suction error determination section 255 determines that a suction error occurs when the calculated value is different from a normal value. If the electronic component D is sucked with a predetermined surface thereof being in a state not parallel to a bottom surface of the suction nozzle 5, such as in an oblique state with respect to the bottom surface of the suction nozzle 5, or sucked with a surface other than the predetermined surface, the calculated value is greater than the actual thickness of the electronic component D. This indicates the state of so-called "component standing". In the case of "component absence" in which the electronic component D is not sucked on the suction nozzle 5, the calculated value is substantially zero. The suction error determination section 255 determines whether a suction error of component absence occurs, based on a predetermined allowable value for the calculated value.

When the suction nozzle 5 having sucked an electronic component D is raised and then the rotary body 6B is rotated to move the electronic component D to the above-mentioned light illumination position, the component detection sensor 32 determines whether there is a suction abnormality based on a light shielding image of the electronic component D.

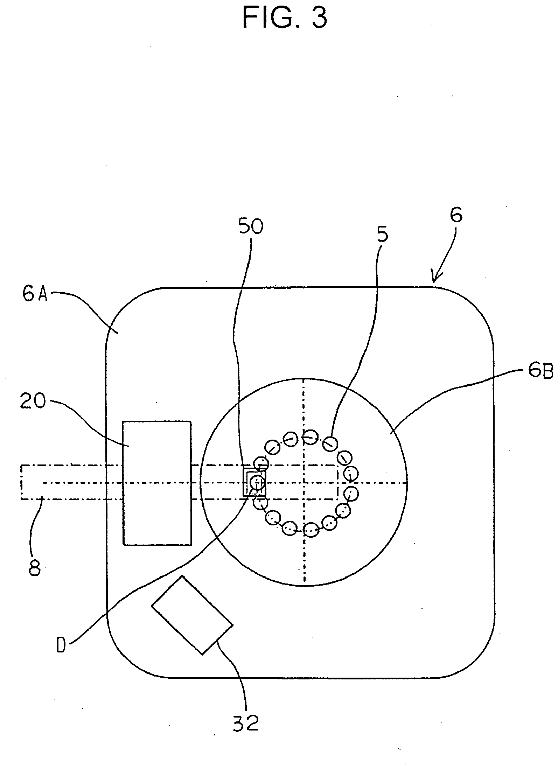

Hereinafter, the mounting head 6 will be described in detail with reference to FIGS. 2 and 3. As described above, the mounting head 6 is movable in the X-Y directions (horizontal directions) by the X-direction movement driving source 16 and the Y-direction movement driving source 15. The rotary body 6B is rotatably supported by the head mounting body 6A. The rotary body 6B is rotationally driven by the θ-axis driving source 17 in the form of a servomotor.

The electronic component mounting apparatus 1 includes imaging cameras 20 which each image the component extraction position. The imaging camera 20 includes a telecentric lens 21 which does not change the magnification of an image of an object to be captured, and an imaging device 22 serving as a photoelectric conversion device, the imaging camera 20 being secured to the head mounting body 6A via a mounting body 23.

Each mounting head 6 is movable without changing the level with respect to the beam 4A, 4B. The suction nozzles 5 are arranged at the same distance from the rotational center of the rotary body 6B. The suction nozzle 5 lowers for component extraction when it is at a predetermined rotational position (at the position of 9 o'clock shown in FIG. 3 that is closest to the beam 4A, 4B: hereinafter the position being referred to as "extraction rotational position") as a result of rotation of the rotary body 6B. The suction nozzle 5 resting at the extraction rotational position lowers from the mounting head 6 and extracts an electronic component D by vacuum suction, the electronic component D having been positioned to the position located directly thereunder at which electronic components D are supplied by the component supply unit 8 (component supply position). Here, the component extraction position means the position of a top surface of the electronic component D placed at the component supply position of the component supply unit 8 that lies directly under the extraction rotational position. The component extraction position is a predetermined position in a planar direction and in the vertical direction.

The present embodiment illustrates the component supply unit 8 which store electronic components D in a tape T. An alternative component feeding device may be adopted in which electronic components D are arranged at predetermined pitches in the X-Y directions on a flat tray.

The imaging camera 20 is attached to the mounting head 6 in such a manner as to be able to image the component extraction position. When the suction nozzle 5 resting at the extraction rotational position is directly above the supply position of electric components D of the component supply unit 8 (when the holder is at the component extraction position), the imaging camera 20 images an electronic component D resting at the component extraction position obliquely from above.

The top surface level of an electronic component D to be placed at the component extraction position is set based on a predetermined reference level. When the top surface level changes due to the thickness of a component or the like, the reference position of the component extraction position in the planar direction is changed. Also when the imaging camera 20 images a mounting position of an electronic component D to allow recognition processing in mounting of the electric component D onto a print substrate P, if the top surface level of the print substrate P differs from the above-mentioned reference top surface level of the electronic component D, a reference position of the mounting position of the component in the planar direction is changed in a similar manner. It should be noted that in the component supply unit 8, the level of the surface of the electronic component D and the level of the surface of the tape T can be considered as substantially equivalent when imaged by the imaging camera 20.

The imaging device 22 of the imaging camera 20 receives reflected light from an electronic component D resting at the component extraction position and a storage portion 50 storing the electronic component D. The reflected light is reflected by a mirror 51 and guided to the imaging camera 22 via the telecentric lens 21 to expose a light receiving surface. The exposure to the light allows the imaging device 22 to obtain an image of the electronic component D and the storage portion 50 storing the electronic component D. A CMOS sensor or a CCD sensor can be adopted as the imaging device 22.

An LED 30 for illumination is attached to a side surface of the imaging camera 20 that receives light to be imaged. When the imaging camera 20 performs imaging, the LED 30 is turned on to illuminate the component extraction position to allow reflected light from the electronic component D to be captured by the imaging camera 20. Sufficient brightness to obtain a sufficiently recognizable image can be ensured if the distance from the LED 30 to the component extraction position or to a component resting at the component supply position of the component supply unit 8 is set in the range of about 10 mm to 20 mm. The LED 30 has a front surface (image receiving surface on the right side of the imaging camera 20 shown in FIG. 2) that is covered with a transparent cover. This covered portion cannot be made to project toward the suction nozzles 5 much because it becomes bright if illuminated with illumination light of the component recognition camera 10. Therefore, the distal end of the projecting covered portion is at the left of the rotary body 6B that is imaged in the background when the component recognition camera 10 images electronic components D.

The LED 30 may be disposed at any position on a lower surface of the mounting head 6, but is preferred to be disposed at a position not too close to the suction nozzles 5 in order to make the background of the suction nozzles 5 dark.

The imaging camera 20 is preferred to be so disposed as to allow an axis (light axis) perpendicular to the receiving surface of the imaging device 22 and passing the center of the telecentric lens 21 to pass the extraction rotational position in a plan view as shown in FIG. 3. Further, the imaging camera 20 is preferred to be disposed at a position at which the axis coincides with the advancing direction of the storage tape T of the component supply unit 8. When the imaging camera 22 is at this position, the suction nozzle 5 at the extraction rotational position can lie closer to the imaging camera 20 than the other suction nozzles 5 not resting at the extraction rotational position. This means that the angle α (see FIG. 2) between the above-mentioned axis and a vertical axis of the suction nozzle 5 can be minimized. Therefore, the above-described disposition of the imaging camera 20 allows the imaging camera 20, in the case of imaging an electronic component D obliquely from above, to image the electronic component D from a position most nearly over the electronic component D. Further, it is possible to locate the component extraction position at the center of a screen which allows an accurate recognition of an image.

However, the position of a storage portion 50 can be recognized as long as the center of the storage portion 50 resting at the component extraction position (the component supply position of the component supply unit 8) is within the image screen even if it is not necessarily at the center of the screen. It is preferred that the whole image of the storage portion 50 is shown in the screen.

An electronic component D to be sucked by the suction nozzle 5 has a certain sufficient size. Therefore, it is necessary to set the angle α to be formed between a light beam travelling from the component extraction position into the imaging camera 20 and the vertical direction, in consideration of the size of the electronic component D. Consequently, the imaging camera 20 images the electronic component D obliquely from above. The imaging camera 20 has a recessed portion 24 in a lower portion on the suction nozzle 5-side thereof so as not to come into contact with a sucked electronic component D when it is an especially large electronic component D.

In the case that the extraction rotational position of the suction nozzles 5 is not at the position of 9 o'clock shown in FIG. 3 but at another position (for example, at the position of 3 o'clock, 12 o'clock or 6 o'clock), the imaging camera 20 may be so attached to the head mounting body 6A as to lie closest to the extraction rotational position. Alternatively, the imaging camera 20 may be disposed at another position on the head mounting body 6A, even if the position lies farther from the extraction rotational position, in a manner able to image the component extraction position of the suction nozzles 5.

The electronic component mounting apparatus 1 includes substrate recognition cameras 55. The substrate recognition camera 55 is disposed on the side of the head mounting body 6A of the mounting head 6 that is adjacent to the beam 4, as shown in FIG. 1. The substrate recognition camera 55 images a position directly thereunder to image a mark for positioning a print substrate P.

Now, a control configuration of the electronic component mounting apparatus 1 will be described with reference to a control block diagram of FIG. 4. The electronic component mounting apparatus 1 includes the controller 25 having a control unit for integrally controlling operations related to the mounting of electronic components D, a determination unit for making various determinations, a comparison unit for making various comparisons, an execution unit, and the like. The electronic component mounting apparatus 1 further includes a recognition processing circuit 28 and a light driving circuit 29.

The controller 25 is in the form of a microcomputer including a ROM and a RAM, and includes a supply detection section 251 (supply detector), a supply control section 252 (supply controller), a head control section 253, a nozzle control section 254 (extraction controller), the above-described suction error detection section 255 (extraction detector), and a storage section 256 that perform a respective function by execution of a predetermined program.

The supply detection section 251 detects whether an electronic component D has been supplied to the predetermined component supply position or whether the supplied electronic component is in an abnormal posture. The supply control section 252 controls the operation of the component supply unit 8 and, in particular, controls the advancing speed of the tape T based on a detection result of the supply detection section 251 in the present embodiment. The head control section 253 controls the drivings of the Y-direction movement driving source 15 and the X-direction movement driving source 16 to thereby control the movement of the mounting head 6. In addition, the head control section 253 controls the driving of the θ-axis driving source 17 to thereby control the rotation of the rotary body 6B. The nozzle control section 24 controls the raising and lowering of the suction nozzle 5 by controlling the driving of the nozzle vertical axis driving source 18. Further, the nozzle control section 254 controls an unillustrated vacuum suction mechanism to thereby control the generation and release of a suction force of the suction nozzle 5. As described above, the suction error determination section 255 detects, after an electronic component D is extracted from the component supply unit 8, whether the electronic component D is held on the suction nozzle 5. Besides, the controller 25 controls the imaging of the imaging camera 20, and the lighting of the LED 30 via the light driving circuit 29.

The storage section 256 stores mounting data including mounting coordinate information indicating the position of an electronic component D in the X-Y directions and its angular position (position in a θ direction) in a print substrate P in the order of mounting step number (for each of the mounting order), mounting data including arrangement number information of the component supply units and the like, component arrangement positional data related to components ID associated with each arrangement number of the component supply unit, and component library data including size data, thickness data and the like of each electronic component, for example.

The controller 25 (the head control section 253, the nozzle control section 254) controls the drivings of the θ-axis driving source 17 for rotating the rotary body 6B, the X-direction movement driving source 16 and the Y-direction movement driving source 15 for the mounting head 6, the nozzle vertical axis driving source 18 for the nozzle 5, and the like, based on data stored in the storage section 256.

The recognition control circuit 28 is connected to the controller 25 and obtains image data from the imaging camera 20. The image data is obtained by the imaging camera 20 imaging an electronic component D that has been positioned to the component supply position (component extraction position of the suction nozzles 5) by the component supply unit 8 and a storage portion 50 storing the electronic component D. Further, the recognition control circuit 28 performs recognition processing of the image data based on an instruction of the controller 25.

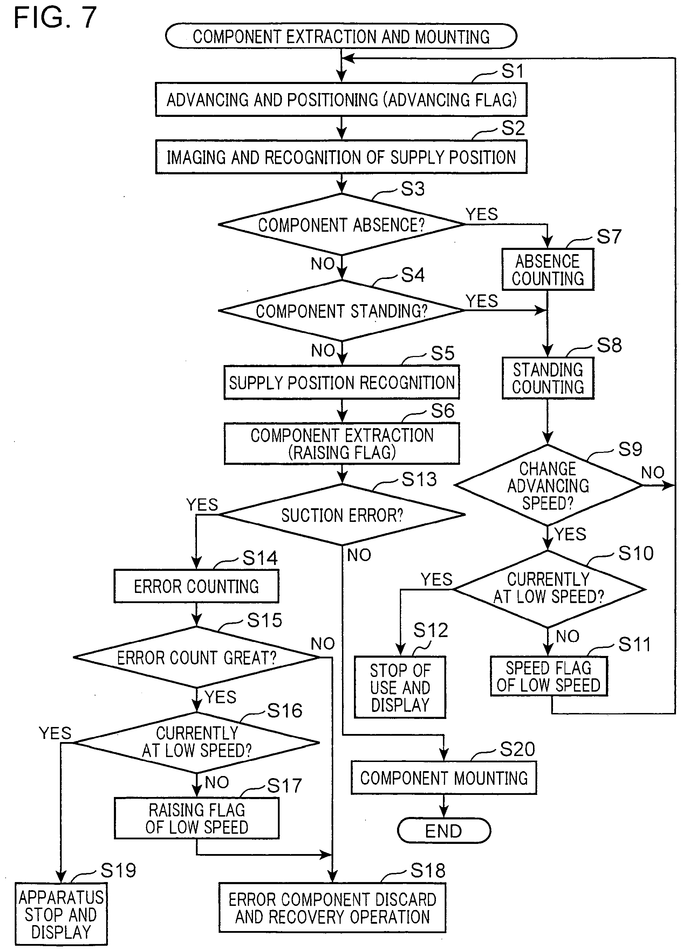

Hereinafter, the extraction and mounting of electronic components D will be described with reference to FIG. 7. An operator pushes an operation start switch portion of a touch panel switch of an unillustrated operation section to carry a print substrate P from an upstream side device into the positioning section of the electronic component mounting apparatus 1 and cause a positioning mechanism to start a positioning operation.

Thereafter, the controller 25 obtains mounting data specifying the XY coordinates and the rotational angle positions about the vertical axis in the print substrate P to which electronic components D should be mounted, the arrangement numbers, and the like stored in the storage section. In accordance with the mounting data, the controller 25 performs such a control that each suction nozzle 5 of the mounting head 6 of the electronic component mounting apparatus 1 extracts, by suction, an electronic component D to be mounted, from the corresponding component supply unit 8.

In other words, the component supply unit 8 that is to supply electronic components D performs an operation of advancing the storage tape T to feed an electronic component D to the component supply position to allow the storage portion 50 storing the electronic component D to be positioned and stopped at the component supply position. At this time, the supply control section 252 of the controller 25 reads an advancing flag stored in the storage section 256, the advancing flag being associated with the relevant component supply unit 8. The supply control section 252 advances the storage tape T at the read speed, and controls the operation of the component supply unit 8 so that the storage portion 50 storing the electronic component D to be subsequently extracted is positioned and stopped at the component supply position. The advancing flag is initially set to a normal speed. When the speed remains unchanged, the storage tape T is advanced at the normal high speed (step S1 in the flowchart of FIG. 7). In parallel with this operation, the head control section 253 moves the mounting head 6 in the X-Y directions along with movement of the beam 4. The head control section 253 stops the mounting head 6 when the suction nozzle 5 at the extraction rotational position reaches a position just over the storage portion 50 positioned at the component supply position of a component supply section of the component supply unit 8.

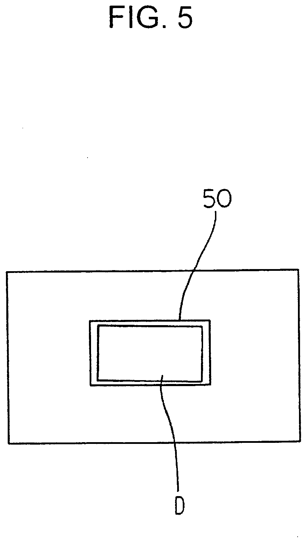

Thereafter, the LED 30 turns on instantaneously to illuminate the component extraction position. The reflected light enters the imaging device 22 of the imaging camera 20 disposed obliquely above the storage portion 50. This allows the imaging device 22 to capture an image of the storage portion 50 and the electronic component D such as the one shown in FIG. 5 (step S2). Image data of the captured image is transferred to the recognition processing circuit 28.

The recognition processing circuit 28 performs recognition processing of the electronic component D based on the image. Thereafter, based on the recognition processing result, the supply detection section 251 of the controller 25 determines whether the electronic component D is stored in the storage portion 50 resting at the component supply position of the component supply unit 8, i.e. determines whether the component is supplied to the predetermined supply position (step S3). Thereafter, the supply detection section 251 determines whether the electronic component D is in an abnormal posture such as the state of so-called "component standing" in the storage portion 50. In other words, recognition processing and determination processing for detecting an abnormal posturing of the supplied component are performed in the recognition processing circuit 28 and the supply detection section 51 (step S4).

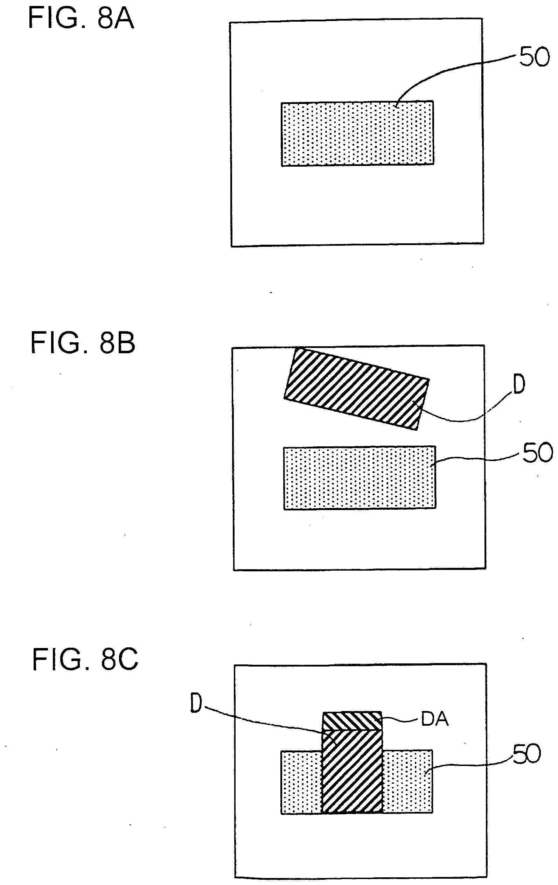

Here, when the electronic component D is normally placed in the storage portion 50, such an image as shown in FIG. 5 is captured. In contrast, in the state of component absence in which the electronic component D is not stored in the storage portion 50, such an image as shown in FIG. 8A is captured. In this case, the recognition processing circuit 28 recognizes only the storage portion (pocket) by the outline (edge) of the pocket. In addition, an image of the electronic component D placed out of the storage portion 50 may be captured as shown in FIG. 8B.

Further, the image shown in FIG. 8C is an image captured when the electronic component D is in a standing posture in the storage portion 50. In the shown image, the electronic component D is indicated by diagonal hatching, the electronic component D having a rectangular parallelepiped shape with six rectangular faces. Here, the electronic component D placed in the storage portion 50 is in a state in which the smallest rectangular faces of the electronic component D extend in parallel to the bottom surface of the storage portion 50. Consequently, the longer rectangular faces of the electronic component D extend substantially perpendicularly to the bottom surface of the storage portion 50, so that the electronic component D projects beyond the storage portion 50 in the standing posture. In FIG. 8C, the above-mentioned smallest face serving as a top surface DA is indicated by diagonal hatching with lines running in a direction different from those indicating the longer rectangular face. The component standing may mean a state of the electronic component D standing completely perpendicularly as described, or a state of the electronic component D placed in the storage portion 50 while riding on the upper edge of the opening of the storage portion 50 with the longer rectangular faces extending obliquely to the bottom surface of the storage portion 50.

The state of "component absence" shown in FIGS. 8A and 8B, in which the electronic component D is not stored in the storage portion 50, can be recognized by using a characteristic amount extraction processing and based on, for example, whether the area of a portion of the storage portion 50 that has high brightness is greater than a certain value. In this case, the brightness is detected at a plurality of spots in the storage portion 50. In the case that the bottom surface of the storage portion 50 is in a color close to black, the state of "component absence" may be determined based on the area of a dark portion. Alternatively, the recognition processing can be performed by pattern matching. Further, also in the case of "component standing" shown in FIG. 8C, the abnormality can be detected by changing the position and the angle of the image of the electronic component D for pattern matching or by detecting a predetermined edge of the electric component D to use the positional relationship between the detected edge and the storage portion 50 for detection of the abnormality.

Alternatively, the supply detection section 251 may be configured to determine occurrence of "component standing" at step S4 in FIG. 7 by recognizing, as an abnormality in the recognition processing, a state in which the electronic component D and the storage portion 50 cannot be divided in the image and therefore the position of the electronic component D or the storage portion 50 cannot be recognized.

Further, "component absence" and "component standing" in a storage portion 50 may be collectively determined as component feeding error without distinction between the absence and the standing. Further, the component feeding error may be determined by recognizing, in the image in which the electronic component D is completely outside the storage portion 50 as shown in FIG. 8B, that there is a foreign matter (electronic component D) outside the storage portion 50.

Although the imaging camera 20 captures a two-dimensional image, it may be configured to obtain a three-dimensional image, for example, by using a plurality of imaging cameras to calculate the height of the electronic component D to thereby allow detection of projection (component standing) of the electronic component D beyond the storage portion 50 (i.e. the top surface of the tape T). Further, the acquisition of the three-dimensional image will also allow detection of absence of the electronic component D in the storage portion 50 by calculating the level of a region constituting its bottom surface. In place of the method of obtaining a three-dimensional image by using a plurality of imaging cameras, a method of disposing a sensor at a position similar to the position of the imaging camera 20 may be adopted, the sensor being capable of detecting the bottom surface level of the storage portion 50.

When the supply detection section 251 determines that the electronic component D is normally stored in the storage portion 50 (i.e. determines that neither the component absence nor the component standing occurs) as shown in the image of FIG. 5, a positional deviation between the component extraction position and the center of the image of the storage portion 50 is detected (step S5). It should be noted that, in the present embodiment, the top surface of the electronic component D is to be at the reference level, and the component extraction position is to be at the center of the screen. In this case, the outline position (positions of edges) of the storage portion 50 is recognized and, because the storage portion 50 has a rectangular shape, the center position of the storage portion 50 is calculated based on the edge positions. It should be noted that the position of the electronic component D may be recognized from the image of the electronic component D itself.

Because the imaging camera 20 performs imaging by using the telecentric lens 21, the lateral dimension of an image is not corrected. On the other hand, the vertical dimension (in the advancing direction of the storage tape T) of the image is shorter than that of the imaged object due to the oblique imaging and, therefore, the vertical dimension is corrected in the recognition processing as necessary. In order to correct a recognized positional deviation, the mounting head 6 moves in the X-Y directions. The suction nozzle 5 starts lowering after termination of the correction movement and sucks the electronic component D (step S6).

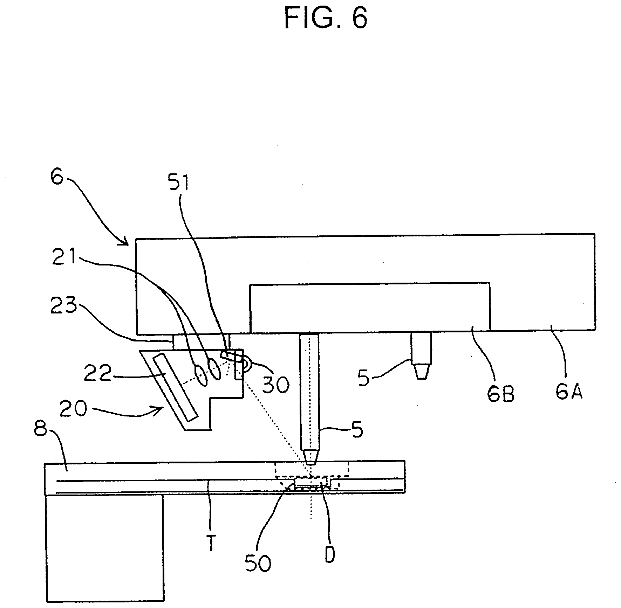

The lowering and the correction movement in the X-Y directions may be performed in parallel, as long as the X-Y correction movement finishes during the lowering of the suction nozzle 5. As shown in FIG. 6, the imaging of the suction nozzle 5 by the imaging camera 20 and the recognition processing are performed each time the suction nozzle 5 stops above the component extraction position, i.e. the component supply position of the component supply unit 8, for extracting a new electronic component D. When the suction nozzle 5 stops above the component extraction position, the storage portion 50 is usually shown in the imaging screen. Even when the positional deviation correction is made thereafter, it is only necessary to horizontally move the mounting head 6 slightly. Therefore, compared to the case where the suction nozzle 5 is moved to the suction position and sucks the electronic component D after the substrate recognition camera 55 captures an image, it is possible to perform the suction at a high speed and increase the productivity.

Because determinations of whether the component absence and the component standing occur are made each time an electronic component D is extracted, it is possible to more accurately detect the state of the electronic component D when it is exposed due to the advancement of the tape T, the peeling of the cover tape, and the like. Also in the case where electronic components D are exposed by cutting the cover tape in the conveyance direction of the tape T instead of peeling the cover tape, the statistical processing of occurrences of the component absence and the component standing can be performed based on the imaging by the imaging camera 20 and the recognition processing.

When the controller 25 determines that the positional deviation in the X-Y directions recognized based on the image captured by the imaging camera 20 is within an allowable range that will cause no problem even if the electronic component D is sucked immediately, the suction nozzle 5 is lowered without performing correction movement of the mounting head 6 in the X-Y directions (horizontal directions) to suck the electronic component D. It should be noted that a method of recognizing a positional deviation of the electronic component D itself instead of recognizing the position of the storage portion 50 may be adopted.

It is desirable to store the captured image such as one of those shown in FIGS. 8A to 8C in association with the respective step of the mounting data in the storage section included in the electronic component mounting apparatus 1 so that an operator can display them on the monitor later and know at which step the displayed electronic component D was sucked. In the case that it is difficult to store all the images, an external computer or the like may be connected to the electronic component mounting apparatus 1 and transfer the image data of captured images sequentially with respective step numbers.

The storage section 256 of the controller 25 includes, for each component supply unit 8, regions for storing a supply component absence counter for counting the number of detections of "component absence" and a component standing counter for counting the number of detections of "component standing". When it is determined, in the recognition processing based on the detection processing of component absence (step S3), that "component absence" occurs (YES at step S3), the supply component absence counter of the storage section 256 corresponding to the relevant component supply unit 8 counts "one" and stores the value (step S7).

Further, when it is determined, in the detection processing of component standing (step S4), that "component standing" occurs (YES at step S4) the component standing counter of the storage section 256 counts "one" and stores the value (step S8).

When either the component absence or the component standing is detected at step S3 or S4, the supply control section 252 of the controller 25 determines whether to change the advancing speed of the tape T based on a predetermined condition (step S9). When the supply control section 252 determines that the condition is satisfied and the advancing speed of the tape T should be changed, in this case, the speed should be reduced (YES at step S9), the supply control section 252 then determines whether the advancing flag stored in the storage section 256 is currently set at "low speed" (step S10). In the initial state, the advancing speed of the tape T is set at "normal" (NO at step S10) and, therefore, the supply control section 252 changes the advancing flag to the "low speed" (step S11). Based on this change, the component supply unit 8 is instructed to change the speed (normal speed) to advance one pitch of the tape T to the low speed.

As a result, in the component supply unit 8, a next storage portion 50 is positioned to the component supply position at the low speed. At this time, the nozzle control section 254 (extraction controller) does not cause the suction nozzle 5 to lower to extract the electronic component D. In other words, the extraction of electronic component D by the suction nozzle 5 is stopped. Therefore, in the case that the electronic component D is placed in the storage portion 50, the tape T is advanced with the electronic component D remaining in the storage portion 50. When the tape T is advanced, the movement starts from the stopped state and accelerates to a predetermined constant speed. The advancement of the tape T at the low speed is preferably realized by making the magnitude of the acceleration less than in the normal mode and also making the absolute value of the deceleration from the predetermined constant speed less than in the normal mode. An alternative method may be adopted which changes a pulse wave to control the advancement of the tape T so that the time period from one stop to the next stop of the tape is longer than in the normal mode.

When the condition of changing the advancing speed is not satisfied at the above-described step S9 (NO at step S9), the tape is advanced while being kept at the normal speed without changing the advancing flag. Thereafter, the component supply position is imaged and, if an electronic component D is normally placed in the storage portion 50, extraction of the electronic component D will be performed.

At this time, regarding the component extraction position to which the suction nozzle 5 is positioned by movement of the mounting head 6, in the case that the position of the storage portion 50 was recognized in the state of component absence, the mounting head 6 may be moved to stop at that position. Alternatively, the suction nozzle 5 may be stopped at a position that served as the component extraction position when the previous extraction of electronic component D was performed.

However, in the case of detection of component standing, it is desirable not to perform recognition processing of the supply position. In the subsequent positioning of the suction nozzle 5 to the component supply position, a recognition result of the component extraction position (supply position) obtained when the previous component extraction was performed may be used.

The extraction position of an electronic component D is recognized for extraction of the electronic component D and, if the suction nozzle 5 lies at a position horizontally deviated from the extraction position, the positional deviation is corrected. After the correction of the positional deviation, the suction nozzle 5 is lowered to suck the electronic component D with the center of the suction nozzle 5 being at the center of a storage portion 50 resting at the supply position.

In the subsequent suction of an electronic component D, the controller 25 stops the mounting head 6 so that the suction nozzle 5 lies at the extraction position, and causes the imaging camera 20 to perform imaging. It may be configured to recognize not the position of the storage portion 50 but the position of the electronic component D itself and perform correction to bring the suction nozzle 5 to the recognized position. Alternatively, in the subsequent extraction of an electronic component D from the same component supply unit 8, the suction nozzle 5 may be located at this previous extraction position of electronic component D before causing the imaging camera 20 to perform imaging.

Here, the condition for the supply control section 252 to change the advancing speed of the tape T at step S9 is, for example, that the total of the component absence count (the number of failures in the supplying of components to the supply position) and the component standing count (abnormal posturings of supplied components) reaches a predetermined number. In the counting of the number of detections, weighting may be given to the component absence count and the component standing count. For example, the total component absence counting may be performed by replacing one detection to two detections. Alternatively, a threshold number may be separately provided for each of the component absence count and the component standing count to reduce the advancing speed of the tape T when one of the count values reaches its threshold value. The predetermined number may be set to the number of continuous occurrences of component absence or component standing.

Further, the supply control section 252 may be configured to determine to reduce the advancing speed of the tape T when the rate of the component absence count or the component standing count with respect to a predetermined number of pitch advancements of the tape T exceeds a predetermined ratio. In the case of using the rate, it is preferable to set the number of pitch advancements in the denominator to the most recent predetermined number. The predetermined number or ratio serving as the threshold may be appropriately set by a user. Further, it is desirable to reset the component absence count and the component standing count to restart from zero when the advancing flag is set to the low speed. In the case of setting the number of continuous occurrences of component absence or component standing as the predetermined number, the count is reset when continuity breaks.

When the advancing flag is set to the low speed at step S11, the component absence count and the component standing count restarts from zero. When it is determined again that the tape advancing speed should be reduced at step 9 in the subsequent routine, because the speed flag is currently set at the low speed (YES at step S10), the component supply unit 8 is stopped being used and a notice informing this state is displayed on the monitor of the apparatus (step S12). The reason why the supply error is not corrected even after the reduction of the tape advancing speed can be due to occurrence of static electricity at the time of peeling the cover tape covering the storage portions 50. Accordingly, it is desirable to additionally display, on the monitor, a message saying "there is a possibility that static electricity occurs" and preferably, in addition, a message encouraging to "generate moisture to eliminate the static electricity".

In the case that an imaged electronic component D is determined to have a scratch or a missing portion as a result of recognition of the top surface condition thereof or determined to be upside down, the electronic component D is discarded without being mounted onto a print substrate P after being sucked on the suction nozzle 5. Alternatively, the storage tape T may be advanced by one pitch to position the subsequent storage portion 50 at the component supply position while leaving such electronic component D unsucked. In the case that, as a result of recognition of an electronic component D, the electronic component D is determined, based on the size or a mark or letter indicating the component type, to be different from the electronic component D specified by the mounting data, the mounting operation may be stopped after displaying a notice informing the abnormality on the monitor. Also in the case that an electronic component D is placed in a wrong polarity, the electronic component D may be advanced without being sucked by the suction nozzle 5 or may be sucked for correction of its direction and then mounted.

Now, the operation that is performed after the extraction of the electronic component D at step S6 will be described. After the suction nozzle 5 sucks the electronic component D and is raised, the suction nozzle 5 having sucked the electronic component D moves to a detection position of the component detection sensor 32 by rotation of the rotary body 6B. At that position, the presence/absence or the position of the sucked electronic component D at the suction nozzle 5 is detected (step S13).

Here, when a suction error is detected such as the absence or abnormal posturing of the electronic component D, the suction error is counted by the suction error determination section 255 (extraction detector) of the controller 25 (step S14). When the error count becomes greater than a set number (YES at step S15), the suction error determination section 255 determines that an abnormality has occurred such as that the electronic component D got stuck when extracted. When the raising speed of the suction nozzle 5 is currently set at the normal speed (NO at step S16), the suction error determination section 255 sets a raising flag of the storage section 256 to a low speed (step S17). Thereafter, the electronic component D in the abnormal sucked position is discarded (step S18). In addition, a recovery operation of extracting an identical electronic component D from the component supply unit 8 again is performed.

When the error count has not reached the set number (NO at step S15), the suction error determination section 255 causes execution of the operation of step S18 without changing the raising flag to the low speed. Also at step S15 for the determination of the suction count, the determination may be made based on the number of continuous occurrences of suction errors. Alternatively, it may be configured to proceed from step S15 to step S16 when the rate of suction errors with respect to a predetermined number of suctions becomes equal to or greater than a predetermined value. When, after the raising flag is set to the low speed, the electronic component D is extracted from the component supply unit 8 for which the flag is set, the nozzle control section 254 performs control of raising the suction nozzle 5 at a lower speed than the normal speed for a predetermined raising distance, for example, a distance until the lower end of the electronic component D comes out of the storage portion 50 and thereafter raising the suction nozzle 5 at the normal speed, in the component extraction.

Alternatively, when the raising flag is set to the low speed, the raising may be suspended at a level where the lower end of the electronic component D is located immediately after coming out of the storage portion 50. This suspension time can be used to wait for the electronic component D that is about to come off the suction nozzle 5 by getting caught on the opening edge of the storage portion 50 to be horizontally sucked again on the lower surface of the suction nozzle 5. Thereafter, the suction nozzle 5 may be raised at the normal speed.

The control according to the flowchart of FIG. 7 allows extraction of an electronic component D stored in a storage portion 50 in a normal position in extraction of the electronic component D at step S6. In other words, after the supply detection section 251 detects that the electric component is supplied by the component supply unit 8 without abnormal posturing and the suction nozzle 5 extracts the electronic component D, the suction error determination section 255 detects the presence/absence of suction error. Thereafter, the nozzle control section 254 controls the raising and lowering of the suction nozzle 5 based on a detection result about suction error. Therefore, it can be seen that the cause for determination at step S13 that a suction error occurs, such as a problem in the storage portion 50, can be addressed when the electronic component D is extracted from the storage portion 50. Accordingly, it is effective to change the control of the raising and lowering, in particular, the raising, of the suction nozzle 5 in the extraction of the electronic component D.

After the raising flag is changed to the low speed, the suction error count at step S14 is reset to zero. If, even when the suction nozzles 5 are raised at the low speed thereafter, suction errors occur in suction of components from the component supply unit 8 and the number of errors exceeds the predetermined number, the operation of the electronic component mounting apparatus 1 of mounting components onto a substrate P is stopped. Thereafter, a notice informing the stop is displayed on the monitor or the like (step S19).

When no suction error is detected by the component detection sensor 32 (NO at step S13), the electronic component D is mounted to a predetermined position on the print substrate P after movement of the mounting head 6 to the substrate P as described later (step S20).

In this manner, every time each of the plurality of suction nozzles 5 of the mounting head 6 moves to and stops at the component supply position of the component supply unit 8 at which an electronic component D to be extracted is supplied, the imaging camera 20 images the component extraction position (i.e. the component supply position of the component supply unit 8) after the electronic component D stops at the component supply position in the component supply unit 8. Thereafter, the above-described recognition processing and the subsequent processing are performed.

When all of the electronic components D respectively held on the suction nozzles 5 of the same mounting head 6 are determined as normal electronic components D, the steadily sucked electronic components D are moved to the position above the component recognition camera 10 by movement of the mounting head 6 in the horizontal directions.

All of the electronic components D held on the plurality of suction nozzles 5 of the mounting head 6 are imaged at once by the recognition camera 10 to allow recognition of its horizontal position with respect to the mounting head 6. When there is a positional deviation, the positional deviation is corrected before the electronic components sucked on the suction nozzles 5 are successively mounted to respective target mounting positions on the print substrate P.

At this time, when the electric component D sucked on the suction nozzle 5 resting at the extraction rotational position is mounted, the controller 25 causes the imaging camera 20 to image the electronic component D under illumination of the LED 30, to make it possible to determine whether the electric component D has been mounted to the correct position based on a relative position with respect to a pattern position or the like of the print substrate P. Alternatively, it is possible for the controller 25 to determine, based on imaging of the component extraction position under the suction nozzle 5 performed before and after the mounting, whether the electronic component D is reliably mounted, i.e. whether the raising is performed without failing to mount the electronic component D and keeping it held. These images may also be stored in the storage section of the electric component mounting apparatus 1 in association with the step numbers of the mounting data, similarly to the images captured at the time of suction. Alternatively, these images may be transferred to an external device.

The present embodiment illustrates the case where extraction of an electronic component D is performed when there is no abnormality in the component supplying, as shown in the flowchart of FIG. 7. In place of the way of leaving an electronic component in the abnormal state unextracted and advancing the subsequent storage portion to the supply position to allow extraction of the subsequent electronic component D, it may be configured, even when component absence or component standing is detected at step S3 or S4 of the above-described flowchart, to extract the electronic component D in the abnormal state without advancing the tape T.

However, even in this case, the countings at steps S7 and S8 are performed, and the determination on whether to change the advancing speed of the tape T is performed. When the extraction of the electronic component D is performed in this manner, the determination of whether suction error occurs is performed by the component detection sensor 32. However, even when a suction error is detected, the detected error may be excluded from the count of suction errors at step S14. This allows the determination of whether suction error occurs to be performed when an electronic component D normally stored in a storage portion 50 is extracted, in the manner as described. As an exemplary case where extraction of an electronic component D positioned at the supply position is performed even when there is a supply error, there is a case where the suction nozzle 5 has already started lowering when the suction nozzle 5 is located at the component extraction position by movement of the mounting head 6 and the lowering cannot be stopped after the imaging and the recognition processing.

In such a case, correction of the component extraction position cannot be made, and information of the component extraction position recognized at this time is used when the subsequent suction of an electronic component D from the component supply unit 8 is performed, in which the suction nozzle 5 is controlled to stop at this position. However, it is preferred not to use the positional information of the recognized storage portion 50 in the case that component standing or the like occurs at the supply position.

It should be noted that the mounting head 6 itself does not raise and lower, and only the suction nozzle 5 raises and lowers. This allows the imaging camera 20 to always image the component extraction position. If the mounting head 6 is configured to raise and lower, the controller 25 may be made to control the timings of lighting of the LED 30 and exposure of the imaging device 22 in such a manner as to allow imaging of the component extraction position when the mounting head 6 is at a predetermined level.

The embodiment of the present invention has been described above, for which various alternate embodiments, modifications and changes can be made based on the above description. Therefore, the present invention includes those various alternate embodiments, modifications and changes without departing from the invention as defined by the appended claims.

According to the above-described invention, it is possible to provide an electronic component mounting apparatus capable of reliably performing extraction of electronic components without reducing the productivity of component mounting as much as possible.

## Claims

1. A component mounting apparatus, comprising:
a component supply unit (8) that is adapted to advance a tape (T) including storage portions (50) storing components to thereby supply a component to a predetermined supply position; and
a holder (5) that is adapted to extract the component from the component supply unit and mount the component onto a substrate;
**characterized by**
a supply detector (251) that is adapted to detect whether the component is in a storage portion (50) of the tape (T) at the supply position or whether the supplied component is in an abnormal posture in the storage portion (50) of the tape (T); and
a supply controller (252) that is adapted to control the advancing speed of the tape based on a detection result of the supply detector (251).

2. The component mounting apparatus according to claim 1, further comprising:
an extraction controller (254) that is adapted to control the holder (5) to stop component extraction when the supply detector (251) detects that no component is in the storage portion (50) or the supplied component is in an abnormal posture.

3. The component mounting apparatus according to claim 1 or 2, wherein
the supply controller (252) is adapted to control the advancing speed of the tape based on the number of abnormal posturings of components supplied by the component supply unit or detections that no component is in the storage portion (50).

4. The component mounting apparatus according to claim 2 or 3, further comprising:
an extraction detector (255, 32) that is adapted to detect whether the holder (5) holds the component after the extraction of the component, wherein
the extraction controller (254) is adapted to control raising and lowering of the holder based on a detection result of the extraction detector after the supply detector (251) detects that the component is supplied by the component supply unit without abnormal posturing and the holder (5) extracts the component.

5. The component mounting apparatus according to claim 4, wherein
the extraction controller (254) is adapted to control the raising and lowering of the holder based on the number of component extraction failures detected by the extraction detector (255, 32) after the supply detector (251) detects that the component is supplied by the component supply unit without abnormal posturing and the holder (5) extracts the component.

6. The component mounting apparatus according to claim 5, wherein
the extraction controller (254) is adapted to control the raising speed of the holder after the component extraction to a speed lower than a normal speed when the number of component extraction failures detected by the extraction detector (255, 32) is equal to or greater than a predetermined number or the extraction failure rate is equal to or greater than a predetermined value.

## Patentansprüche

1. Bauteilmontageeinrichtung umfassend:
eine Bauteilzuführeinheit (8), die angepasst ist, ein Band (T) umfassend Lagerabschnitte (50), die Bauteile lagern, vorzuschieben, um somit ein Bauteil einer vorbestimmten Zuführposition zuzuführen; und
einen Halter (5), der angepasst ist, das Bauteil von der Bauteilzuführeinheit zu entnehmen und das Bauteil auf ein Substrat zu montieren;
**dadurch gekennzeichnet, dass**
ein Zuführdetektor (251), der angepasst ist, zu erfassen, ob sich das Bauteil in einem Lagerabschnitt (50) des Bands (T) an der Zuführposition befindet oder ob sich das zugeführte Bauteil in einer abnormen Stellung in dem Lagerabschnitt (50) des Bands (T) befindet; und
eine Zuführsteuerung bzw. Zuführregelung (252), die angepasst ist, die Vorschubgeschwindigkeit des Bands basierend auf einem Erfassungsergebnis des Zuführdetektors (251) zu steuern bzw. zu regeln.

2. Bauteilmontageeinrichtung nach Anspruch 1, ferner umfassend:
eine Entnahmesteuerung bzw. Entnahmeregelung (254), die angepasst ist, den Halter (5) zu steuern bzw. zu regeln, sodass er die Bauteilentnahme stoppt, wenn der Zuführdetektor (251) erfasst, dass sich kein Bauteil in dem Lagerabschnitt (50) befindet oder sich das zugeführte Bauteil in einer abnormen Stellung befindet.

3. Bauteilmontageeinrichtung nach Anspruch 1 oder 2, wobei die Zuführsteuerung bzw. Zuführregelung (252) angepasst ist, die Vorschubgeschwindigkeit des Bands basierend auf der Anzahl der abnormen Stellungen der Bauteile, die von der Bauteilzuführeiriheit zugeführt werden, oder auf Erfassungen, dass sich kein Bauteil in dem Lagerabschnitt (50) befindet, zu steuern bzw. zu regeln.

4. Bauteilmontageeinrichtung nach Anspruch 2 oder 3, ferner umfassend:
einen Entnahmedetektor (255, 32), der angepasst ist, zu erfassen, ob der Halter (5) das Bauteil nach der Entnahme des Bauteils hält, wobei
die Entnahmesteuerung bzw. Entnahmeregelung (254) angepasst ist, Heben und Senken des Halters basierend auf einem Erfassungsergebnis des Entnahmedetektors zu steuern bzw. zu regeln, nachdem der Zuführdetektor (251) erfasst, dass das Bauteil von der Bauteilzuführeinheit ohne abnorme Stellung zugeführt wird und der Halter (5) das Bauteil entnimmt.

5. Bauteilmontageeinrichtung nach Anspruch 4, wobei
die Entnahmesteuerung bzw. Entnahmeregelung (254) angepasst ist, Heben und Senken des Halters basierend auf der Anzahl der von dem Entnahmedetektor (255, 32) erfassten Bauteilentnahmefehler zu steuern bzw. zu regeln, nachdem der Zuführdetektor (251) erfasst, dass das Bauteil von der Bauteilzuführeinheit ohne abnorme Stellung zugeführt wird und der Halter (5) das Bauteil entnimmt.

6. Bauteilmontageeinrichtung nach Anspruch 5, wobei
die Entnahmesteuerung bzw. Entnahmeregelung (254) angepasst ist, die Hebegeschwindigkeit des Halters nach der Bauteilentnahme zu einer Geschwindigkeit zu steuern bzw. zu regeln, die geringer ist als eine normale Geschwindigkeit, wenn die Anzahl der von dem Entnahmedetektor (255, 32) erfassten Bauteilentnahmefehler gleich oder größer als eine vorbestimmte Anzahl ist oder die Entnahmefehlerrate gleich oder größer als ein vorbestimmter Wert ist.

## Revendications

1. Appareil de montage de composants comportant :
une unité d'apport de composants (8) qui est adaptée pour faire avancer une bande (T) incluant des portions de stockage (50) stockant des composants pour ainsi apporter un composant à une position d'apport prédéfinie ; et
un système de maintien (5) qui est adapté pour extraire le composant de l'unité d'apport de composants et monter le composant sur un substrat ;
**caractérisé par**
un détecteur d'apport (251) qui est adapté pour détecter si le composant est dans une portion de stockage (50) de la bande (T) à la position d'apport ou si le composant apporté est dans une position anormale dans la portion de stockage (50) de la bande (T) ; et
un contrôleur d'apport (252) qui est adapté pour commander la vitesse d'avancement de la bande sur la base des résultats de détection du détecteur d'apport (251).

2. Appareil de montage de composants selon la revendication 1, comportant en outre :
un contrôleur d'extraction (254) qui est adapté pour commander l'élément de maintien (5) afin d'arrêter l'extraction de composants lorsque le détecteur d'apport (251) détecte qu'aucun composant n'est dans la portion de stockage (50) ou que le composant apporté est dans une position anormale.

3. Appareil de montage de composants selon la revendication 1 ou 2, dans lequel
le contrôleur d'apport (252) est adapté pour commander la vitesse d'avancement de la bande sur la base du nombre de positions anormales de composants apportés par l'unité d'apport de composants ou de détections qu'aucun composant n'est dans la portion de stockage (50).

4. Appareil de montage de composants selon la revendication 2 ou 3, comportant en outre :
un détecteur d'extraction (255, 32) qui est adapté pour détecter si l'élément de maintien (5) maintient le composant après l'extraction du composant, dans lequel
le contrôleur d'extraction (254) est adapté pour commander l'élévation et l'abaissement de l'élément de maintien sur la base d'un résultat de détection du détecteur d'extraction après que le détecteur d'apport (251) a détecté que le composant est apporté par l'unité d'apport de composants sans position anormale et que l'élément de maintien (5) extrait le composant.

5. Appareil de montage de composants selon la revendication 4, dans lequel
le contrôleur d'extraction (254) est adapté pour commander l'élévation et l'abaissement de l'élément de maintien sur la base du nombre d'échecs d'extraction de composants détecté par le détecteur d'extraction (255, 32) après que le détecteur d'apport (251) a détecté que le composant est apporté par l'unité d'apport de composants sans position anormale et que l'élément de maintien (5) extrait le composant.

6. Appareil de montage de composants selon la revendication 5, dans lequel
le contrôleur d'extraction (254) est adapté pour commander la vitesse d'élévation de l'élément de maintien après l'extraction de composants à une vitesse inférieure à une vitesse normale lorsque le nombre d'échecs d'extraction de composants détecté par le détecteur d'extraction (255, 32) est égal ou supérieur à un nombre prédéfini ou que le taux d'échec d'extractions est égal ou supérieur à une valeur prédéfinie.
